# EUROPEAN PATENT SPECIFICATION

(11) **EP 4 604 690 B1**
(45) Date of publication and mention of the grant of the patent: **30.09.2026**
(21) Application number: 24223665.1
(22) Date of filing: 30.12.2024
(51) Int. Cl.: H10D 30/67

(54) **THIN-FILM TRANSISTOR AND DISPLAY DEVICE INCLUDING THE SAME**
DÜNNSCHICHTTRANSISTOR UND ANZEIGEVORRICHTUNG DAMIT
TRANSISTOR À COUCHES MINCES ET DISPOSITIF D'AFFICHAGE LE COMPRENANT

(30) Priority: 19.02.2024 KR 20240023447
(43) Date of publication of application: 20.08.2025
(60) Divisional application: 26197631.0
(73) Proprietor: LG Display Co., Ltd., Seoul, 07336 (KR)
(72) Inventor: IM, Seoyeon, 10845 Paju-si, Gyeonggi-do (KR)
(74) Representative: Viering, Jentschura & Partner mbB Patent- und Rechtsanwälte

(56) References cited:
- US-A1- 2020 212 221
- US-A1- 2021 202 754
- US-A1- 2023 014 588

## Description

### BACKGROUND

### Field

The present disclosure relates to a thin-film transistor and a display device including the thin-film transistor.

### Description of Related Art

A display device is used in a variety of devices such as televisions, monitors, smart phones, tablet PCs, laptops, and wearable devices.

The display device may display an image through a number of pixels included in a display area.

In this case, each pixel may include at least one thin-film transistor that may individually control each pixel.

Recently, consumer demand for an ultra-high resolution display device is increasing, and thus, the display area is required to include a larger number of pixels.

When an area size occupied by each pixel included in the display area is reduced, a size of an element such as the thin-film transistor included in the pixel may be reduced.

US 2021/202754 A1 discloses a thin film transistor, a display apparatus comprising the thin film transistor, and a method for manufacturing the thin film transistor. The thin film transistor comprises an active layer, and a gate electrode spaced apart from the active layer and configured to have at least a portion overlapped with the active layer, wherein the active layer includes a silicon semiconductor layer, and an oxide semiconductor layer which contacts the silicon semiconductor layer, wherein at least a portion of the silicon semiconductor layer and at least a portion of the oxide semiconductor layer are overlapped with the gate electrode.

US 2020/212221 A1 discloses that a thin film transistor includes an active layer including a channel portion; a gate electrode spaced apart from the active layer and overlapping at least a part of the active layer; and source and drain electrodes connected with the active layer and spaced apart from each other, wherein the channel portion includes, a first boundary portion connected with one of the source and drain electrodes; a second boundary portion connected with the other one of the source and drain electrodes; and a main channel portion interposed between the first boundary portion and the second boundary portion, and wherein at least a part of the second boundary portion has a thickness smaller than a thickness of the main channel portion.

US 2023/014588 A1 discloses a thin film transistor array substrate and an electronic device. The thin film transistor array includes a first active layer including a first area, a second area spaced apart from the first area, and a channel area provided between the first area and the second area, a first gate electrode disposed on the first active layer, and a second gate electrode disposed on the same layer as the first gate electrode to overlap one end of the first gate electrode and to which a signal corresponding to a signal applied to the first gate electrode is applied.

### SUMMARY

As a specification of the display devices increases, it is also required that a high current be applied to the thin-film transistor that operates to control each pixel.

In one of schemes for applying high current to the thin-film transistor, an active layer of the thin-film transistor may be made of a high-carrier mobility oxide semiconductor material.

However, when the active layer is made of the high-carrier mobility oxide semiconductor material, hot carrier stress (HCS) may occur in a channel area adjacent to a drain electrode of the thin-film transistor.

The hot carrier stress may be described as follows.

When the drain voltage applied to the thin-film transistor increases beyond a certain value, electrons migrating through the channel area have strong migration energy, thereby causing strong collisions of the electrons in the channel area near the drain area.

Due to such strong collisions of the electrons, defects may occur in the channel area near the drain area, or a hot carrier stress phenomenon in which the electrons are trapped may occur.

When the hot carrier stress phenomenon occurs, current characteristics of the thin-film transistor element decreases, which may lead to a defect in which a certain pixel in the display panel does not properly operates.

In particular, when the active layer is made of the high-carrier mobility oxide semiconductor material, a possibility at which the hot carrier stress occurs may increase due to a high carrier concentration.

In this way, when the active layer of the thin-film transistor is made of a high-carrier mobility oxide semiconductor material, the high current may be imparted to the thin-film transistor, while the occurrence of the hot carrier stress phenomenon may lead to reduced current characteristics of the transistor or the defect of the transistor.

Accordingly, through various experiments, the inventors of the present disclosure have invented a thin-film transistor that may reduce the occurrence of the hot carrier stress phenomenon while including a high-carrier mobility active layer, and a display device including the same.

A purpose according to an embodiment of the present disclosure is to provide a thin-film transistor that may reduce the occurrence of the hot carrier stress phenomenon and a display device including the same.

In addition, a purpose according to an embodiment of the present disclosure is to provide a thin-film transistor with high luminance and a display device including the same.

In addition, a purpose according to an embodiment of the present disclosure is to provide a thin-film transistor that may facilitate control of a threshold voltage and a display device including the same.

In addition, a purpose according to an embodiment of the present disclosure is to provide a thin-film transistor that may increase productivity and reliability of the active layer and achieve production energy saving via process optimization, and a display device including the same.

In addition, a purpose according to an embodiment of the present disclosure is to provide a thin-film transistor that is advantageous in terms of grayscale expression and a display device including the same.

Purposes according to the present disclosure are not limited to the above-mentioned purpose. Other purposes and advantages according to the present disclosure that are not mentioned may be understood based on following descriptions, and may be more clearly understood based on embodiments according to the present disclosure. Further, it will be easily understood that the purposes and advantages according to the present disclosure may be realized using means shown in the claims or combinations thereof.

According to an aspect of the present disclosure, a thin-film transistor according to claim 1 is provided. Further embodiments are described in the dependent claims. A thin-film transistor according to an embodiment of the present disclosure includes an active layer, a first electrode connected to one side of the active layer, a second electrode connected to an opposite side of the active layer to one side, and a gate electrode disposed on top of the active layer. The active layer includes a first active layer connected to the first electrode and a second active layer connected to the second electrode, and a carrier mobility of the first active layer is lower than a carrier mobility of the second active layer. The second active layer includes a second lower active layer including a partial area that is covered with the first active layer, and a second upper active layer extending from the second lower active layer and covering at least a partial area of the first active layer that covers the second lower active layer.

According to another aspect of the present disclosure, a thin-film transistor according to claim 6 is provided. Further embodiments are described in the dependent claims. A thin-film transistor according to an embodiment of the present disclosure includes an active layer, a first electrode connected to one side of the active layer, a second electrode connected to an opposite side of the active layer that is opposite to the one side of the active layer, and a gate electrode disposed on top of the active layer. The active layer includes a first active layer connected to the first electrode and a second active layer connected to the second electrode, and a carrier mobility of the first active layer is less than a carrier mobility of the second active layer. The first active layer includes a first lower active layer including a partial area that is covered with the second active layer, and a first upper active layer extending from the first lower active layer and covering at least a partial area of the second active layer that covers the first lower active layer.

According to an embodiment of the present disclosure, the carrier mobility of the first active layer connected to the first electrode is lower than the carrier mobility of the second active layer connected to the second electrode. Thus, even when the second active layer is made of a high-carrier mobility material, the occurrence of the hot carrier stress in the first active layer may be reduced.

Further, according to an embodiment of the present disclosure, a significant area of an effective channel area of the active layer constituting the main channel may be made of a relatively high carrier mobility material. Thus, high current may be allowed to flow through the thin-film transistor, such that a display device with high luminance may be realized.

Further, according to an embodiment of the present disclosure, as the active layer is formed as a stack of a plurality of layers with different carrier mobility, it is easier to control a threshold voltage in the active layer based on high current characteristics.

In addition, according to an embodiment of the present disclosure, as the active layer is formed as a stack of a plurality of layers with different carrier mobility, a limited range on process conditions as required in a process of forming the active layer may be expanded, compared to forming the active layer as a single layer.

Accordingly, not only may the productivity and reliability of the active layer be improved, but production energy savings may be achieved through process optimization.

Further, according to an embodiment of the present disclosure, the S-factor value may be increased by electrically connecting the light blocking layer disposed under the thin-film transistor to the source electrode thereof. Thus, the display device may express sufficient gradations. This may be advantageous in terms of the gradation expression.

Effects of the present disclosure are not limited to the effects mentioned above, and other effects not mentioned will be clearly understood by those skilled in the art from the descriptions below.

### BRIEF DESCRIPTION OF DRAWINGS

FIG. 1 is a schematic plan view of a display device according to an embodiment of the present disclosure and not in accordance with the claimed invention.
FIG. 2 is a circuit diagram of one sub-pixel of a display device according to an embodiment of the present disclosure and not in accordance with the claimed invention.
FIG. 3 is a cross-sectional view of a thin-film transistor according to a first embodiment of the present disclosure and not in accordance with the claimed invention.
FIG. 4 is a cross-sectional view of a thin-film transistor according to a second embodiment of the present disclosure and not in accordance with the claimed invention.
FIG. 5 is a cross-sectional view of a thin-film transistor according to a third embodiment of the present disclosure and not in accordance with the claimed invention.
FIG. 6 is a cross-sectional view of a thin-film transistor according to a fourth embodiment of the present disclosure and in accordance with the claimed invention.
FIG. 7 is a cross-sectional view of a thin-film transistor according to a fifth embodiment of the present disclosure and not in accordance with the claimed invention.
FIG. 8 is a cross-sectional view of a thin-film transistor according to a sixth embodiment of the present disclosure and in accordance with the claimed invention.
FIG. 9 is a cross-sectional view of a thin-film transistor according to a seventh embodiment of the present disclosure and in accordance with the claimed invention.

### DETAILED DESCRIPTIONS

Advantages and features of the present disclosure, and a method of achieving the advantages and features will become apparent with reference to embodiments described later in detail together with the accompanying drawings. However, the present disclosure is not limited to the embodiments as disclosed under, but may be embodied in various different forms. Thus, these embodiments are set forth only to make the present disclosure complete, and to completely inform the scope of the present disclosure to those of ordinary skill in the technical field to which the present disclosure belongs, and the present disclosure is only defined by the scope of the claims.

A shape, a size, a ratio, an angle, a number, etc. disclosed in the drawings for illustrating embodiments of the present disclosure are illustrative, and the present disclosure is not limited thereto. For simplicity and clarity of illustration, elements in the drawings are not necessarily drawn to scale. The same reference numbers in different drawings represent the same or similar elements, and as such perform similar functionality. Further, descriptions and details of well-known steps and elements are omitted for simplicity of the description. Furthermore, in the following detailed description of the present disclosure, numerous specific details are set forth in order to provide a thorough understanding of the present disclosure. However, it will be understood that the present disclosure may be practiced without these specific details. In other instances, well-known methods, procedures, components, and circuits have not been described in detail so as not to unnecessarily obscure aspects of the present disclosure. The terminology used herein is directed to the purpose of describing particular embodiments only and is not intended to be limiting of the present disclosure. As used herein, the singular constitutes "a" and "an" are intended to include the plural constitutes as well, unless the context clearly indicates otherwise. It will be further understood that the terms "comprise", "comprising", "include", and "including" when used in this specification, specify the presence of the stated features, integers, operations, elements, and/or components, but do not preclude the presence or addition of one or more other features, integers, operations, elements, components, and/or portions thereof.

In interpreting a numerical value, the value is interpreted as including an error range unless there is no separate explicit description thereof.

Further, as used herein, when a layer, film, region, plate area, or the like is be disposed "on" or "on a top" of another layer, film, region, plate area, or the like, the former may directly contact the latter or still another layer, film, region, plate area, or the like may be disposed between the former and the latter. As used herein, when a layer, film, region, plate area, or the like is directly disposed "on" or "on a top" of another layer, film, region, plate area, or the like, the former directly contacts the latter and still another layer, film, region, plate area, or the like is not disposed between the former and the latter. Further, as used herein, when a layer, film, region, plate area, or the like is disposed "below" or "under" another layer, film, region, plate area, or the like, the former may directly contact the latter or still another layer, film, region, plate area, or the like may be disposed between the former and the latter. As used herein, when a layer, film, region, plate area, or the like is directly disposed "below" or "under" another layer, film, region, plate area, or the like, the former directly contacts the latter and still another layer, film, region, plate area, or the like is not disposed between the former and the latter.

In descriptions of temporal relationships, for example, temporal precedent relationships between two events such as "after", "subsequent to", "before", etc., another event may occur therebetween unless "directly after", "directly subsequent" or "directly before" is not indicated.

It will be understood that, although the terms "first", "second", "third", and so on may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described under could be termed a second element, component, region, layer or section, without departing from the scope of the present disclosure.

The features of the various embodiments of the present disclosure may be partially or entirely combined with each other, and may be technically associated with each other or operate with each other. The embodiments may be embodied independently of each other and may be embodied together in an association relationship.

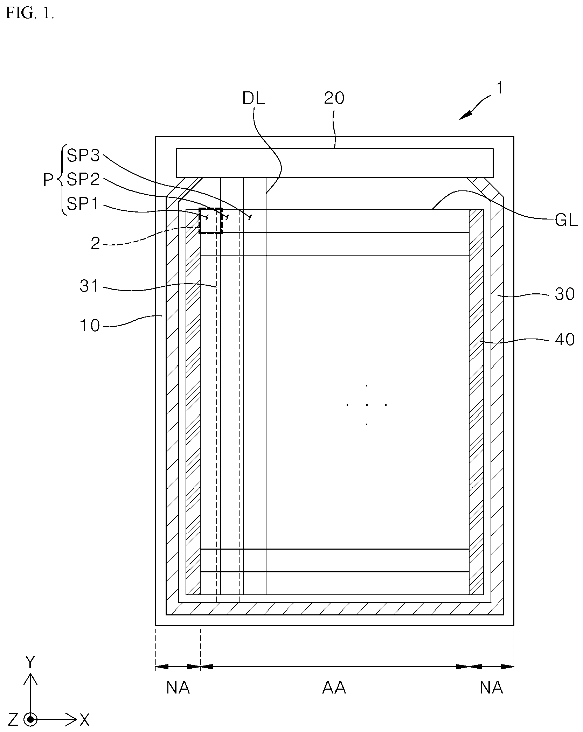

Hereinafter, with reference to FIG. 1 to FIG. 2, a display device according to an exemplary embodiment of the present disclosure will be described in detail.

FIG. 1 is a schematic plan view of a display device according to an exemplary embodiment of the present disclosure.

An example in which a display device 1 is embodied as an organic electroluminescent display device (for example, organic light-emitting diode display device) is described below. However, embodiments of the present disclosure are not limited thereto.

The display device 1 may include a substrate 10 including a display area AA and a non-display area NA that surrounds the display area AA.

In the display area AA of the substrate 10, a plurality of data lines DL extending in a first direction and a plurality of gate lines GL extending in a second direction that intersects the first direction may be arranged.

Each of a plurality of sub-pixels such as sub-pixels SP1, SP2, and SP3 may be disposed in each of intersections of the data lines DL and the gate lines GL.

The sub-pixels SP1, SP2, and SP3 may emit light of the same color, such as white (W) light, or red (R), green (G), or blue (B) light, or may emit light beams of different colors.

A combination of the plurality of sub-pixels SP1, SP2, and SP3 as described above may constitute one pixel P, without being limited thereto. More or less sub-pixels may constitute one pixel P.

The plurality of sub-pixels SP1, SP2, and SP3 may be arranged in a plurality of rows and columns in a matrix format.

As used herein, the first direction may be a column or vertical direction and may be defined as a Y-axis direction, and the second direction may be a row or horizontal direction and may be defined as a X-axis direction, without being limited thereto. In another example, the first direction may be the row or horizontal direction, and the second direction may be the column or vertical direction.

A number of lines and pads that supply various signals and powers to the pixel may be disposed on the non-display area NA of the substrate 10, without being limited thereto.

A data driver circuit (D-IC) 20 may be disposed in one side area of the non-display area NA.

The data driver circuit 20 may be a circuit for driving the plurality of data lines, and may apply a data signal to the data line DL, and may apply a driving voltage such as a high potential voltage VDD or a low potential voltage VSS to the pixel P.

A power line 30 may extend along an edge of the display area AA and in an side area of the non-display area NA other than the side area in which the data driver circuit 20 is disposed, without being limited thereto.

For example, a gate driver 40 that applies a gate signal to the gate line GL may be disposed in the non-display area NA and located on each of both opposing sides of the display area AA. For example, the gate driver 40 may be a circuit for driving a plurality of gate lines. The power line 30 capable of applying a voltage to an anode electrode or a cathode electrode in the pixel P may extend along an outer edge of the gate driver 40 and in the non-display area NA.

The power line 30 may include a low-potential voltage line capable of applying a low-potential voltage VSS to the cathode electrode of the pixel P. However, embodiments of the present disclosure are not limited thereto. For example, the power line 30 may further include a high-potential voltage line capable of applying a high-potential voltage VDD to a thin-film transistor of the pixel P.

A plurality of power connection lines 31 may be disposed in the display area AA and may electrically connect the power line 30 to the plurality of sub-pixels SP1, SP2, and SP3and may be disposed between the power line 30 and the plurality of sub-pixels SP1, SP2, and SP3 and may apply the low potential voltage to the plurality of sub-pixels SP1, SP2, and SP3.

For example, the plurality of power connection lines 31 may extend in the first direction in which the plurality of data lines DL extend by an equal length, without being limited thereto.

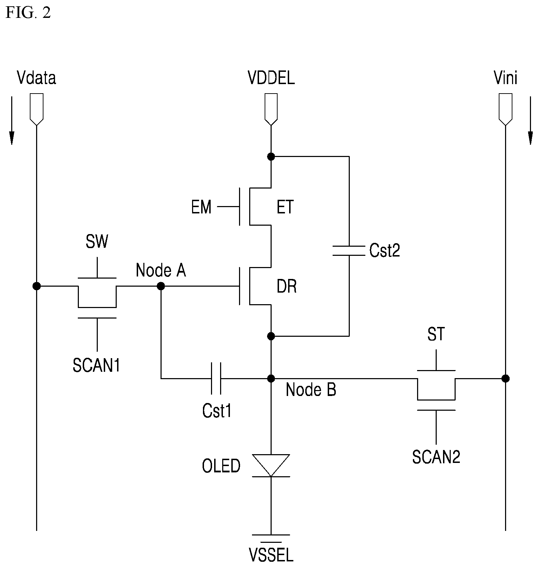

FIG. 2 is a circuit diagram of one sub-pixel of a display device according to an exemplary embodiment of the present disclosure.

An example in which the sub-pixel is implemented based on a 4T (transistor) 2C (capacitor) structure is described. However, embodiments of the present disclosure are not limited thereto. For example, 3T1C, 4T1C, 5T1C, 3T2C, 5T2C, 6T2C, 7T1C, 7T2C, 8T2C structures, etc. are also possible. And more or less transistors and capacitors could be included.

For example, the sub-pixel includes a first storage capacitor Cst1, a second storage capacitor Cst2, a switching transistor SW, a light-emission control transistor ET, a sensing transistor ST, a driving transistor DR, and light-emitting element OLED, as shown in FIG. 2. However, embodiments of the present disclosure are not limited thereto. More or less elements are also possible.

Each of the switching transistor SW, the light-emission control transistor ET, and the sensing transistor ST may act as a switch.

A first scan signal SCAN1, a second scan signal SCAN2, and a third scan signal EM may be provided to the sub-pixel via the gate line GL, and a data voltage Vdata may be provided to the sub-pixel via the data line DL.

The switching transistor SW may be used to apply the voltage of the data line DL to a node A. For example, when the switching transistor SW is turned on in response to the first scan signal SCAN1, the voltage of the data line DL is applied to the node A.

The switching transistor SW may be turned on or turned off based on the first scan signal SCAN1.

The node A may be connected to a gate electrode of the driving transistor DR. That is, the node A may be between the switching transistor SW and the driving transistor DR.

The sensing transistor ST may be used to apply an initialization voltage Vini to a node B to initialize a circuit while a compensation operation is performed. For example, when the sensing transistor ST is turned on in response to the second scan signal SCAN2, the initialization voltage Vini is applied to the node B.

The sensing transistor ST may be turned on or turned off based on the second scan signal SCAN2.

The light-emission control transistor ET may be turned on or off based on the third scan signal EM.

The driving transistor DR may be turned on or off based on the data voltage.

The switching transistor SW may perform a switching operation to store the data voltage Vdata in the first capacitor Cst1 in response to the first scan signal SCAN1. The first capacitor Cst1 may be disposed between the node A and the node B.

The driving transistor DR may operate so that a driving current flows between a high-potential power line VDDEL and a low-potential power line VSSEL based on the data voltage stored in the first capacitor Cst1.

The driving transistor DR may be turned on based on the data voltage to control current flowing through the light-emitting element OLED to display an image.

The light-emitting element OLED may emit light based on a current of a high potential voltage transmitted via the driving transistor DR.

One side of the light-emitting element OLED may be connected to the node B, and the other side thereof may be connected to the low-potential power line VSSEL. For example, the anode electrode of the light-emitting element OLED may be connected to the node B, and the cathode electrode thereof may be connected to the low-potential power line VSSEL.

In the present disclosure, the light-emitting element OLED may be embodied as an organic light-emitting diode. However, embodiments of the present disclosure are not limited thereto. Various types of light-emitting elements may be used as the light-emitting element.

The second capacitor Cst2 may be a compensation capacitor and, for example, may compensate for a threshold voltage of the driving transistor DR.

One side of the second capacitor Cst2 may be connected to one side of the driving transistor DR, and the other side thereof may be connected to the other side of the light-emission control transistor ET. The other side of the driving transistor DR may be connected to one side of light-emission control transistor ET.

Each of the switching transistor SW and the sensing transistor ST may have a double gate structure in which gate electrodes are located on top of and under one active layer, respectively.

As each of the switching transistor SW and the sensing transistor ST has the double gate structure, switching performance may be improved by improving on-off characteristics of the transistor.

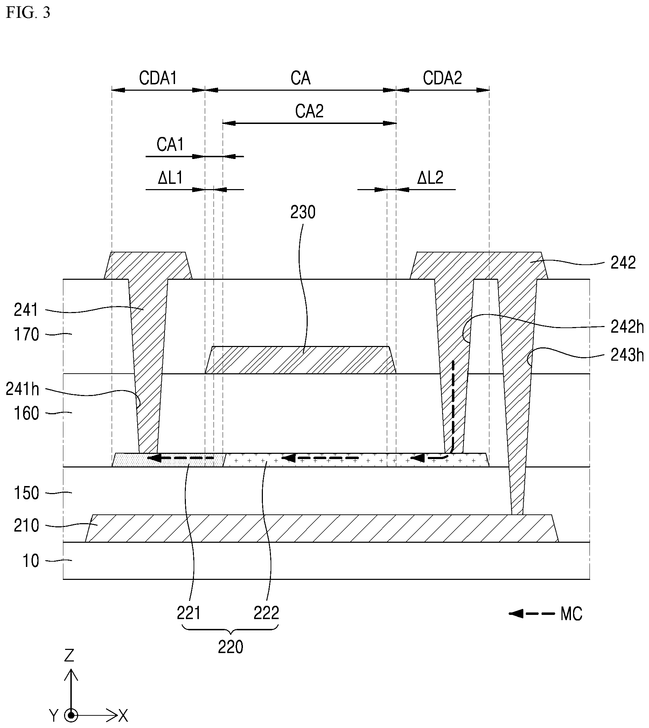

Hereinafter, with reference to FIG. 3, a thin-film transistor according to a first exemplary embodiment of the present disclosure will be described in detail.

The thin-film transistor described in the present disclosure may be a driving thin-film transistor as the driving transistor DR. However, embodiments of the present disclosure are not limited thereto.

Referring to FIG. 3, a substrate 10 may be disposed, and the substrate 10 may be referred to as a thin-film transistor substrate.

Glass, plastic such as polyimide, or a flexible polymer film may be used as a material of the substrate 10. However, embodiments of the present disclosure are not limited thereto.

A light blocking layer 210 may be disposed on the substrate 10. Specifically, the light blocking layer 210 may be disposed on a portion of the substrate 10.

The light blocking layer 210 may protect an active layer 220 of the thin-film transistor by blocking light incident from an outside.

Accordingly, the light blocking layer 210 may be disposed to overlap the active layer 220 in a vertical direction.

The vertical direction in FIG. 3 may mean a Z-axis direction, without being limited thereto.

The light blocking layer 210 may be formed to have a larger area than that of the active layer 220, and thus may effectively protect the active layer 220 of the thin-film transistor by blocking light incident from a position under the active layer 220.

A buffer layer 150 may be disposed on the light blocking layer 210. Specifically, the buffer layer 150 may be disposed on the light blocking layer 210 and the portion of the substrate 10 that is exposed by the light blocking layer 210.

The buffer layer 150 may be composed of a single or double layer made of silicon oxide (SiOx) or silicon nitride (SiNx). However, embodiments of the present disclosure are not limited thereto.

The buffer layer 150 may protect the active layer 220 by blocking air and moisture.

The active layer 220 may be disposed on the buffer layer 150. Specifically, the active layer 220 may be disposed on a portion of the buffer layer 150.

The active layer 220 includes a first active layer 221 and a second active layer 222 having different carrier mobility, without being limited thereto.

The first active layer 221 and the second active layer 222 may be arranged side by side and may be disposed in the same plane, without being limited thereto.

For example, the first active layer 221 and the second active layer 222 may be arranged side by side and may be disposed on the buffer layer 150, without being limited thereto.

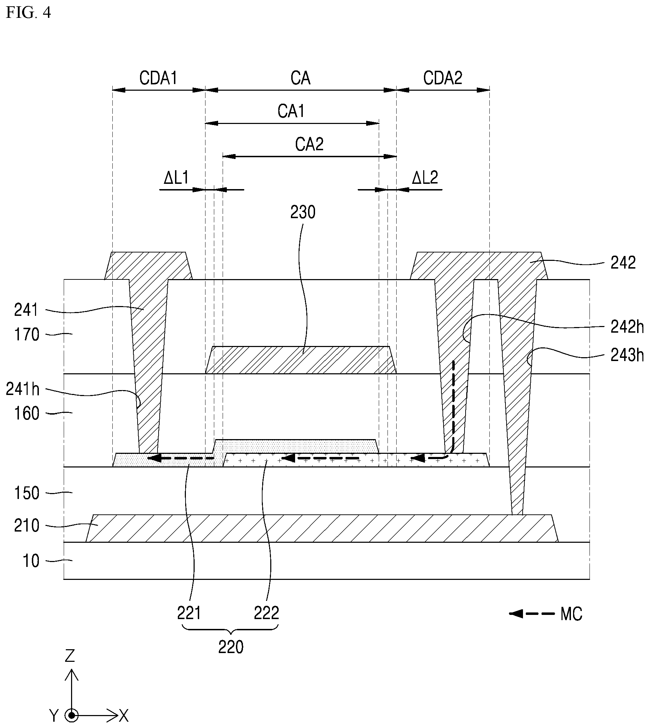

Each of the first active layer 221 and the second active layer 222 may be formed as a single layer, without being limited thereto. In another example, the active layer 220 may be formed as a double layer stack composed of two layers, that, lower and upper level layers, as shown in FIG. 4.

As shown in FIG. 3, a length in a left-right direction of the second active layer 222 may be larger than a length in the left-right direction of the first active layer 221.

The left-right direction as indicated in FIG. 3 may refer to the X-axis direction.

Each of the first active layer 221 and the second active layer 222 may include an oxide semiconductor material, without being limited thereto.

As one example, the first active layer 221 has lower carrier mobility than that of the second active layer 222.

Accordingly, the first active layer 221 may be made of an oxide semiconductor material with a first carrier mobility, and the second active layer 222 may be made of an oxide semiconductor material with a second carrier mobility higher than the first carrier mobility. For example, the first active layer 221 may be made of an oxide semiconductor material with low carrier mobility, and the second active layer 222 may be made of an oxide semiconductor material with high carrier mobility.

As used herein, the low carrier mobility and the high carrier mobility are relative concepts. Mobility values of the first active layer 221 and the second active layer 222 are compared to each other, and a relatively lower carrier mobility value may be referred to as the low carrier mobility, and a relatively higher carrier mobility value may be referred as the high carrier mobility.

In one example, the first active layer 221 of the low carrier mobility may include at least one of an IGZO (InGaZnO)-based oxide semiconductor material [Ga concentration ≥ In concentration], a GZO (GaZnO)-based oxide semiconductor material, an IGO (InGaO)-based oxide semiconductor material, and a GZTO (GaZnSnO)-based oxide semiconductor material. However, embodiments of the present disclosure are not limited thereto.

For example, the first active layer 221 may have a carrier mobility ranging from approximately 5 cm²/V·s to 12 cm²/V·s. However, embodiments of the present disclosure are not limited thereto.

In one example, the second active layer 222 of the high carrier mobility may include at least one of an IGZO (InGaZnO)-based oxide semiconductor material [In concentration > Ga concentration], an IZO (InZnO)-based oxide semiconductor material, an IGZTO (InGaZnSnO)-based oxide semiconductor material, a ITZO (InSnZnO)-based oxide semiconductor material, a FIZO (FeInZnO)-based oxide semiconductor material, a ZnO-based oxide semiconductor material, a SIZO (SiInZnO)-based oxide semiconductor material, and a ZnON (Zn-Oxynitride)-based oxide semiconductor material. However, embodiments of the present disclosure are not limited thereto.

For example, the second active layer 222 may have a carrier mobility ranging from approximately 20 cm²/V·s to 50 cm²/V·s. However, embodiments of the present disclosure are not limited thereto.

A gate insulating layer 160 may be disposed on the active layer 220. Specifically, the gate insulating layer 160 may be disposed on the active layer 220 and the portion of the buffer layer 150 that is exposed by the active layer 220.The gate insulating layer 160 may be composed of a single or double layer of silicon oxide (SiOx) or silicon nitride (SiNx). However, embodiments of the present disclosure are not limited thereto.

A gate electrode 230 may be disposed on the gate insulating layer 160. Specifically, the gate electrode 230 may be disposed on a portion of the gate insulating layer 160.

The gate electrode 230 may be disposed to overlap the active layer 220 in the vertical direction.

The gate electrode 230 may be formed to have a smaller area than that of the active layer 220, without being limited thereto.

An interlayer insulating layer 170 may be disposed on the gate electrode 230. Specifically, the interlayer insulating layer 170 may be disposed on the gate electrode 230 and the portion of the gate insulating layer 160 exposed by the gate electrode 230.

The interlayer insulating layer 170 may be composed of a single or double layer of silicon oxide (SiOx) or silicon nitride (SiNx). However, embodiments of the present disclosure are not limited thereto.

A first electrode 241 and a second electrode 242 may be disposed on the interlayer insulating layer 170. Specifically, the first electrode 241 and the second electrode 242 may be disposed on a portion of the interlayer insulating layer 170.

The first electrode 241 may be connected to the first active layer 221 as one portion of the active layer 220 via a first contact hole 241h extending through the interlayer insulating layer 170 and the gate insulating layer 160.

One area of the active layer 220 where the first active layer 221 is located may be defined as a first area. That is, the first electrode 241 may be connected to the first area via the first contact hole 241h extending through the interlayer insulating layer 170 and the gate insulating layer 160.

In addition, the second electrode 242 may be connected to the second active layer 222 as the other portion of the active layer 220 via a second contact hole 242h extending through the interlayer insulating layer 170 and the gate insulating layer 160.

The other area of the active layer 220 where the second active layer 222 is located may be defined as a second area. That is, the second electrode 242 may be connected to the second area via the second contact hole 242h extending through the interlayer insulating layer 170 and the gate insulating layer 160.

In addition, the second electrode 242 may be connected to the light blocking layer 210 via a third contact hole 243h extending through the interlayer insulating layer 170, the gate insulating layer 160, and the buffer layer 150, without being limited thereto.

Accordingly, the active layer 220 and the light blocking layer 210 may be electrically connected to each other via the second electrode 242.

Therefore, the light blocking layer 210 according to an exemplary embodiment of the present disclosure may be electrically connected to the second electrode 242. However, embodiments of the present disclosure are not limited thereto. In another embodiment, the light blocking layer 210 may not be in contact with the second electrode 242, but may be connected to another electrode or line so as to be connected to a ground electrode.

According to an exemplary embodiment of the present disclosure, electrically connecting the second electrode 242 and the light blocking layer 210 disposed under the thin-film transistor to each other may allow a S-factor value to be increased. Thus, the display device may express sufficient gradations, which may be advantageous in terms of gradation expression.

The S-factor is referred to as "subthreshold slope" and indicates a voltage required when the current increases by 10 times. In a graph (I-V curve) showing characteristics of a drain current relative to a gate voltage, the S-factor value is a reciprocal value of a slope of the graph (I-V curve) in a range below the threshold voltage.

A small S-factor value means that the slope of the characteristic graph I-V of the drain current relative to the gate voltage is large.

Therefore, the thin-film transistor may be turned on even under a small voltage, and the switching characteristics of the thin-film transistor may be improved.

On the other hand, since the voltage reaches the threshold voltage in a short time, it may be difficult to express sufficient gray levels.

Conversely, a large S-factor value means that the slope of the characteristic graph I-V of the drain current relative to the gate voltage is small.

Therefore, the switching characteristics of the thin-film transistor may deteriorate due to decrease in an on/off response speed of the thin-film transistor, while sufficient grayscale expression may be achieved because the voltage reaches the threshold voltage over a relatively long period of time.

When the light blocking layer 210 disposed under the active layer 220 is not connected to the second electrode 242, the light blocking layer 210 plays the same role as that of the gate electrode, such that the switching characteristics of the transistor may be improved.

However, as described above, when the switching characteristics are improved, the voltage reaches the threshold voltage in a short time, thus making it difficult to express sufficient grayscale. Therefore, the light blocking layer 210 according to an exemplary embodiment of the present disclosure may be electrically connected to the second electrode 242, such that the thin-film transistor may provide for sufficient grayscale expression.

In another embodiment, the light blocking layer 210 may not be in contact with the second electrode 242, but may be connected to another electrode or line so as to be connected to a ground electrode.

The first electrode 241 may be a drain electrode, and the second electrode 242 may be a source electrode. However, embodiments of the present disclosure are not limited thereto. In another embodiment, the first electrode 241 may be the source electrode, and the second electrode 242 may be the drain electrode.

The thin-film transistor may include the active layer 220, the gate electrode 230, the first electrode 241, and the second electrode 242 formed in this way.

The thin-film transistor according to an exemplary embodiment of the present disclosure is constructed so that the first electrode 241 and the second electrode 242 have an asymmetric structure with each other, and may be configured as a unidirectional element in which current flows only in a direction from the second electrode 242 to the first electrode 241. However, embodiments of the present disclosure are not limited thereto.

As shown in FIG. 3, an area of the active layer 220 that overlaps the gate electrode 230 in the vertical direction may be a channel area CA.

Accordingly, an area of each of the first active layer 221 and the second active layer 222 constituting the active layer 220 overlapping the gate electrode 230 in the vertical direction may be the channel area CA. For example, the channel area CA may comprise a first channel area CA1 and a second channel area CA2.

As discussed above, the length in a left-right direction of the second active layer 222 may be larger than a length in the left-right direction of the first active layer 221. For example, a length of the second channel area CA2 may be larger than a length of the first channel area CA1.

For example, an area where the first active layer 221 of the active layer 220 and the gate electrode 230 overlap each other in the vertical direction may be the first channel area CA1. An area where the second active layer 222 of the active layer 220 and the gate electrode 230 overlap each other in the vertical direction may be the second channel area CA2.

An area of the active layer 220 that does not overlap the gate electrode 230 in the vertical direction may be a conductivized area CDA1 and CDA2. For example, the channel area CA may be disposed between the conductivized area CDA1 and conductivized area CDA2.

For example, the channel area CA and the conductivized area CDA1 and CDA2 may be formed in the active layer 220 by plasma treatment or hydrogen treatment using the gate electrode 230 as a mask.

The first active layer 221 connected to the first electrode 241 may act as the first conductivized area CDA1 in an area thereof that does not overlap with the gate electrode 230. The first active layer 221 connected to the first electrode 241 may act as the first channel area CA1 in an area thereof that overlaps with the gate electrode 230.

The first active layer 221 may be positioned so that a partial area thereof overlaps the gate electrode 230 in the vertical direction so as to act as the first channel area CA1. The first active layer 221 may be positioned so that a partial area thereof does not overlap with the gate electrode 230 in the vertical direction so as to act as the first conductivized area CDA1.

The second active layer 222 connected to the second electrode 242 may act as the second conductivized area CDA2 in an area thereof that does not overlap with the gate electrode 230. The second active layer 222 connected to the second electrode 242 may act as the second channel area CA2 in an area thereof that overlaps with the gate electrode 230.

The second active layer 222 may be positioned such that a partial area thereof overlaps the gate electrode 230 in the vertical direction so as to act as the second channel area CA2. The second active layer 222 may be positioned such that a partial area thereof does not overlap with the gate electrode 230 in the vertical direction so as to act as the second conductivized area CDA2.

In this case, the second active layer 222 may be formed to have a larger overlapping area with the gate electrode 230 than an area of the first active layer 221 overlapping with the gate electrode 230. That is, the area of the second channel area CA2 may be larger than that of the first channel area CA1.

Accordingly, a length of the second channel area CA2 of the high carrier mobility may be larger than the length of the first channel area CA1 of the low carrier mobility.

A main portion of the channel area CA through which a larger number of carriers migrate may be referred to as a main channel area. A portion of the channel area CA through which a smaller number of carriers migrate may be referred to as a sub-channel area.

However, depending on a stacking type of the active layer 220, the channel area may include the sub-channel area in addition to the main channel area.

The carriers may migrate in the sub-channel area. However, a smaller number of carriers may migrate in the sub-channel area, compared to the main channel area.

When the active layer 220 is formed as a single layer, both the second channel area CA2 and the first channel area CA1 arranged side by side and disposed in the same plane may be the main channel areas.

The first channel area CA1 and the second channel area CA2 may be arranged so as not to overlap each other in the vertical direction, without being limited thereto.

Accordingly, main current MC flowing may flow from the second electrode 242 to the first electrode 241 via the second channel area CA2 and the first channel area CA1. For example, main current MC flowing may flow from the source electrode to the drain electrode via the second channel area CA2 and the first channel area CA1, without being limited thereto.

In this case, since the length of the second channel area CA2 of the high carrier mobility is larger than the length of the first channel area CA1 of the low carrier mobility, the second channel area CA2 of the high carrier mobility may occupy a significant portion of the main channel area.

According to an exemplary embodiment of the present disclosure, the significant portion of the main channel area in the channel area CA of the active layer 220 may be made of a relatively high carrier mobility material, so that high current may be allowed to flow through the thin-film transistor. Thus, a display device with high luminance may be realized.

A first boundary area ΔL1 and a second boundary area ΔL2 may be disposed at one side of the channel area CA adjacent to the first conductivized area CDA1 and the other side of the channel area CA adjacent to the second conductivized area CDA2, respectively.

As previously described, each of the first conductivized area CDA1 and the second conductivized area CDA2 may be formed by conductivizing the area of the active layer 220 excluding the channel area CA. For example, the first conductivized area CDA1 may be formed by conductivizing the area of the first active layer 221 excluding the channel area CA, and the second conductivized area CDA2 may be formed by conductivizing the area of the second active layer 222 excluding the channel area CA.

However, in a process of conductivizing the portion of the active layer 220 into the conductive portion, a portion of the channel area CA adjacent to each of the first conductivized area CDA1 and the second conductivized area CDA2 may be partially subjected to the conductivizing process into the conductive portion.

Thus, the portion of the channel area CA adjacent to the first conductivized area CDA1 may be partially subjected to the conductivizing process into the conductive portion and thus may become the first boundary area ΔL1.

The first boundary area ΔL1 may be disposed in the first channel area CA1 of the first active layer 221. The first channel area CA1 may be adjacent to the first conductivized area CDA1.

Further, the portion of the channel area CA adjacent to the second conductivized area CDA2 may be partially subjected to the conductivizing process into the conductive portion and thus may become the second boundary area ΔL2.

The second boundary area ΔL2 may be disposed in the second channel area CA2 of the second active layer 222. The second channel area CA2 may be adjacent to the second conductivized area CDA2.

Each of the first boundary area ΔL1 and the second boundary area ΔL2 may have a higher carrier concentration than that of the channel area CA. However, embodiments of the present disclosure are not limited thereto.

The first boundary area ΔL1 and the second boundary area ΔL2 may have a Fermi level similar to those of the first conductivized area CDA1 and the second conductivized area CDA2, respectively. However, embodiments of the present disclosure are not limited thereto.

In this way, the conductivity of the first boundary area ΔL1 and the second boundary area ΔL2 as both opposing edges of the channel area CA may increase in the process in which the portion of the active layer 220 is converted into the first conductivized area CDA1 and the second conductivized area CDA2.

Lengths of the first boundary area ΔL1 and the second boundary area ΔL2 may be referred to as a first conductivization penetration length ΔL1 and a second conductivization penetration length ΔL2, respectively.

An area corresponding to a portion of the channel area CA excluding the first conductivization penetration length ΔL1 and the second conductivization penetration length ΔL2 in a total length of the channel area CA may be defined as an effective channel area.

The length of the first channel area CA1 may exceed at least the first conductivization penetration length ΔL1.

Accordingly, in the first active layer 221, an area corresponding to a length excluding the first conductivization penetration length ΔL1 in a total length of the first channel area CA1 may become a first effective channel area. Thus, in the first active layer 221, the effective channel area with the low carrier mobility may be secured.

Similarly, in the second active layer 222, an area corresponding to a length excluding the second conductivization penetration length ΔL2 in a total length of the second channel area CA2 may become a second effective channel area. Thus, in the second active layer 222, the effective channel area with the high carrier mobility may be secured.

In this way, in the first active layer 221, the effective channel area with the low carrier concentration and thus the low carrier mobility may be secured. Thus, even when current flows from the second electrode 242 to the first electrode 241, the possibility at which the hot carrier stress occurs may be greatly reduced.

In this way, in the second active layer 222, the effective channel area with the high carrier concentration and thus the high carrier mobility may be secured.

According to an exemplary embodiment of the present disclosure as described as above, the carrier mobility of the first active layer 221 connected to the first electrode 241 is lower than that of the second active layer 222 connected to the second electrode 242. Thus, even when the second active layer 222 is made of the high-carrier mobility material, the occurrence of the hot carrier stress in the first active layer 221 may be reduced.

That is, the first active layer 221 connected to the first electrode 241 may be formed to have the low carrier mobility, the carrier concentration in the first channel area CA1 may be reduced. Even when current flows in the unidirectional direction from the second electrode 242 to the first electrode 241, the occurrence of the hot carrier stress in the first active layer 221 near the first channel area CA1 may be reduced.

Further, according to an exemplary embodiment of the present disclosure, the first active layer 221 and the second active layer 222 having different carrier mobilities may be arranged side by side and may be disposed in the same layer, and each thereof may be formed as a single layer, without being limited thereto. Specifically, the carrier mobility of the first active layer 221 connected to the first electrode 241 is lower than that of the second active layer 222 connected to the second electrode 242. Thus, deterioration of a step coverage of the gate insulating layer 160 formed on the first active layer 221 and the second active layer 222 may be reduced.

As the degradation of the step coverage of the gate insulating layer 160 is reduced, the stabilization effect of device characteristics may be obtained.

Hereinafter, FIG. 4 to FIG. 9 will be referred to respectively to describe thin-film transistors according to some further embodiment of the present disclosure.

However, in second to seventh embodiments as described below, the descriptions of contents duplicate with those about the thin-film transistor according to the first exemplary embodiment as described above with reference to FIG. 3 will be omitted or briefly given. Rather, following descriptions focus on different configurations thereof therefrom.

Referring to FIG. 4, in the thin-film transistor according to the second exemplary embodiment, the first active layer 221 may extend toward the second electrode 242 so that the first active layer 221 covers a top surface of the second active layer 222, without being limited thereto. In the first exemplary embodiment of FIG. 3, the first active layer 221 and the second active layer 222 may be arranged side by side and may be disposed in the same plane.

Therefore, the active layer 220 may be formed as a double layer stack composed of two layers, that, lower and upper level layers, without being limited thereto. In the first exemplary embodiment of FIG. 3, each of the first active layer 221 and the second active layer 222 may be formed as a single layer.

For example, a portion of the first active layer 221 and the second active layer 222 may be disposed in a lower level layer of the stack. The other portion of the first active layer 221 may extend from the first active layer 221 of the lower level layer and may be disposed in an upper level layer of the stack. That is, the other portion of the first active layer 221 of the upper level layer may cover a top surface of the second active layer 222 of the lower level layer.

In this case, the first channel area CA1 of the first active layer 221 may become larger by a length by which the first active layer 221 extends from the first active layer 221 of the lower level layer so as to be disposed in the upper level layer of the stack.

As the first active layer 221 is disposed to cover the top surface of the second active layer 222, the top surface of the first active layer 221 may be closer to the gate electrode than the top surface of the second active layer 222 may be.

As the first active layer 221 of the upper level layer is located closer to the gate electrode 230 than the second active layer 222 is, a gate field may be strongly applied to the first active layer 221, so that the first channel area CA1 of the active layer 221 may act as the main channel area.

In this way, when the first channel area CA1 of the low carrier mobility becomes the main channel area, it may be difficult to achieve the high current characteristic effect of the thin-film transistor.

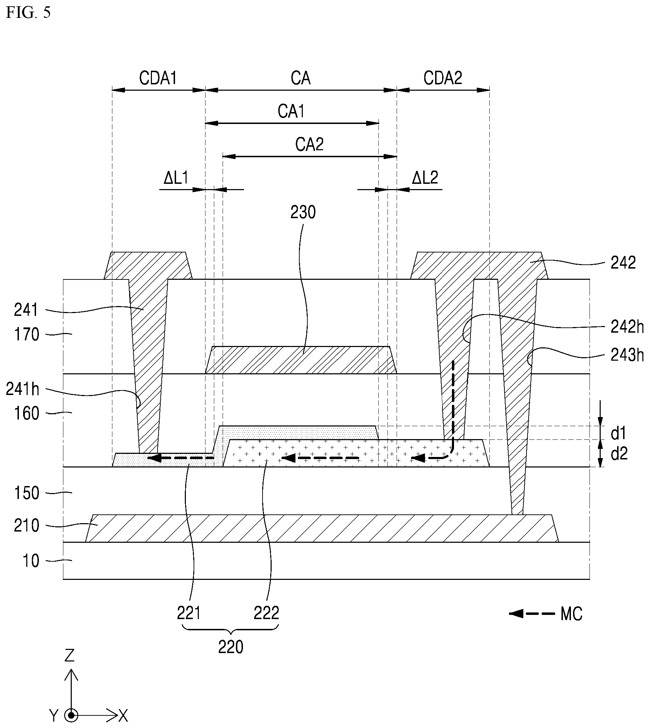

Accordingly, according to an exemplary embodiment of the present disclosure, a difference between the carrier mobility of the second active layer 222 and the carrier mobility of the first active layer 221 may be set to be larger, and thus the second channel area CA2 of the second active layer 222 relatively further away from the gate electrode 230 may act as the main channel area. However, embodiments of the present disclosure are not limited thereto. As another example, a thickness d2 of the second active layer 222 may be set be larger than a thickness d1 of the first active layer 221, as shown in FIG. 5.

As one example, the carrier mobility of the second active layer 222 may be set to be higher by at least approximately 10 cm²/V·s than the carrier mobility of the first active layer 221. However, embodiments of the present disclosure are not limited thereto.

Accordingly, instead of the first channel area CA1 of the first active layer 221 closer to the gate electrode 230 than the second active layer 222 is, the second channel area CA2 of the second active layer 222 relatively further away from the gate electrode 230 may act as the main channel area. Thus, it is possible to achieve the high current characteristic effect of the thin-film transistor.

Therefore, referring to FIG. 4, the main current MC flowing from the second electrode 242 may flow through the second channel area CA2 and the first channel area CA1 in the lower level layer of the stack and then may flow to the first electrode 241.

In one example, the first channel area CA1 located in the upper level layer may function as a protective capping layer that protects the second channel area CA2 located in the lower level layer, and thus the reliability of the thin-film transistor may be improved.

During a process of forming the thin-film transistor, the active layer 220 constituting the channel area CA may be damaged during many processes for forming the thin-film transistor.

In this case, a portion of the first channel area CA1 of the first active layer 221 in the upper level layer which does not constitute the main channel area covers the upper of the second channel area CA2. Thus, the first channel area CA1 of the first active layer 221 of the upper level layer may function to prevent the damage to the second channel area CA2 of the lower level layer acting as the main channel area.

As the damage to the second channel area CA2 acting as the main channel area may be reduced, the reliability of the thin-film transistor may be improved.

Further, referring to FIG. 5, in the thin-film transistor according to the third exemplary embodiment of the present disclosure, a thickness d2 of the second active layer 222 may be larger than a thickness d1 of the first active layer 221, and thus the second channel area CA2 of the second active layer 222 relatively further away from the gate electrode 230 may act as the main channel area. Thus, it is possible to achieve the high current characteristic effect of the thin-film transistor.

When the thickness d2 of the second active layer 222 is larger than the thickness d1 of the first active layer 221, the second channel area CA2 of the second active layer 222 disposed under the first channel area CA1 of the first active layer 221 may act as the main channel area even though the difference between the carrier mobility of the second active layer 222 and the carrier mobility of the first active layer 221 is not set to be larger. However, embodiments of the present disclosure are not limited thereto. As another example, the thickness d2 of the second active layer 222 may be set to be larger than the thickness d1 of the first active layer 221, and the difference between the carrier mobility of the second active layer 222 and the carrier mobility of the first active layer 221 may be set to be larger, thereby further achieving the high current characteristic effect of the thin-film transistor.

As the thickness of the second channel area CA2 of the second active layer 222 increases, a stronger gate field may be applied to the second channel area CA2.

Accordingly, instead of the first channel area CA1 of the first active layer 221 closer to the gate electrode 230 than the second active layer 222 is, the second channel area CA2 of the second active layer 222 relatively further away from the gate electrode 230 may act as the main channel area. Thus, it is possible to achieve the high current characteristic effect of the thin-film transistor.

Therefore, referring to FIG. 5, the main current MC flowing from the second electrode 242 may flow through the second channel area CA2 of the lower level layer and the first channel area CA1 of the lower level layer and then may flow to the first electrode 241.

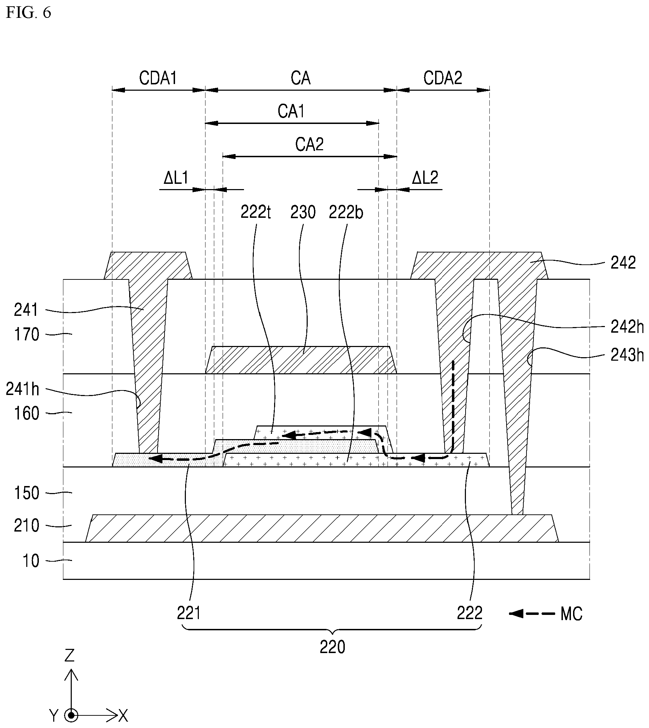

Referring to FIG. 6, the thin-film transistor according to the fourth exemplary embodiment of the present disclosure may include a multi-layer active layer 220 composed of a stack of three layers.

The second active layer 222 includes a second lower active layer 222b disposed so that a partial area thereof is covered with the first active layer 221, and a second upper active layer 222t extending from the second lower active layer 222b so as to cover at least a partial area of the first active layer 221 covering the second lower active layer 222b. That is, a portion of the first active layer 221 may be disposed between the second lower active layer 222b and the second upper active layer 222t, without being limited thereto.

For example, the first active layer 221 and the second active layer 222 may be disposed in a lower level layer, the first active layer 221 may be disposed in a middle level layer, and the second active layer 222 may be disposed in a upper level layer. Specifically, a portion of the first active layer 221 and the second lower active layer 222b may be disposed in the lower level layer, the other portion of the first active layer 221 may be disposed in the middle level layer, and the second upper active layer 222t may be disposed in the upper level layer, without being limited thereto.

The first active layer 221 of the lower level layer and the first active layer 221 of the middle level layer may be connected to each other along a side surface of the second active layer 222 of the lower level layer. The second active layer 222 of the lower level layer and the second active layer 222 of the upper level layer may be connected to each other along a side surface of the first active layer 221 of the middle level layer.

In this case, the second upper active layer 222t and the second lower active layer 222b may be formed to have the same carrier mobility. However, embodiments of the present disclosure are not limited thereto.

For example, the first active layer 221 may be made of an oxide semiconductor material with low carrier mobility, and the second active layer 222 may be made of an oxide semiconductor material with high carrier mobility.

Additionally, the second upper active layer 222t and the second lower active layer 222b may be formed in different processes.

For example, after forming the second lower active layer 222b and forming the first active layer 221, the second upper active layer 222t may be additionally formed.

The second upper active layer 222t may not cover a partial area of the first channel area CA1 of the first active layer 221, so that a partial area of the first channel area CA1 of the first active layer 221 may be directly exposed to the gate electrode 230, without being limited thereto.

For example, the second upper active layer 222t may extend as much as possible such that an end thereof may not invade the first boundary area ΔL1.

The active layer 220 is constructed such that the first active layer 221 of the low carrier mobility is surrounded with the second active layer 222 of the high carrier mobility in a sandwiched manner, and the first active layer 221 of the low carrier mobility spaces upper and lower portions of the second active layer 222 of the high carrier mobility from each other.

That is, the active layer 220 may be constructed such that the active layers having different carrier mobilities are alternately stacked on top of each other in the vertical direction.

Since the second upper active layer 222t is located closest to the gate electrode 230 and has the high carrier mobility, the second upper active layer 222t may constitute the main channel area. Thus, it is possible to achieve the high current characteristic effect of the thin-film transistor.

Therefore, referring to FIG. 6, the main current MC flowing from the second electrode 242 may flow through the partial area of the second channel area CA2 of the second lower active layer 222b of the lower level layer and then may flow through the second channel area CA2 of the second upper active layer 222t of the upper level layer, and may flow through the first channel area CA1 of the first active layer 221 of the middle and lower level layers and then may flow to the first electrode 241.

The second lower active layer 222b located in the lower level layer may function as a carrier support layer that supplements the carriers into the second upper active layer 222t.

In order to increase the intensity of the current passing through the second channel area CA2 of the second upper active layer 222t, the carrier mobility of the second upper active layer 222t may be further increased or the thickness thereof may be increased. As the thickness of the second upper active layer 222t increases, a stronger gate field may be applied to the second channel area CA2 of the second upper active layer 222t.

However, when the carrier mobility of the second upper active layer 222t is excessively increased, the influence of the main channel area adjacent to the gate electrode 230 may become excessively large.

Accordingly, a threshold voltage of the thin-film transistor may change, and it may be difficult to control an interface between the second upper active layer 222t constituting the main channel area and the gate insulating layer 160.

Therefore, instead of directly increasing the carrier mobility of the second upper active layer 222t, a scheme of indirectly increasing the carrier mobility of the second upper active layer 222t, for example, transferring the carrier of the second lower active layer 222b to the second upper active layer 222t may be applied to the thin-film transistor according to the present disclosure. That is, the second lower active layer 222b located in the lower level layer may function as a carrier support layer that supplements the carriers into the second upper active layer 222t.

For example, the strong gate field acts in an area where the voltage applied to the gate electrode 230 is high. Thus, the gate field is affected by the second lower active layer 222b of the lower level layer. Thus, as the carriers in the second lower active layer 222b migrate to the second upper active layer 222t, the carriers may be supplemented to the second upper active layer 222t.

As the carriers are supplemented to the second upper active layer 222t, the carrier mobility of the second upper active layer 222t indirectly increases. Thus, the intensity of the current passing through the second channel area CA2 of the second upper active layer 222t may be increased while maintaining the stability of the threshold voltage of the thin-film transistor.

Accordingly, a portion of the first active layer 221 between the second upper active layer 222t and the second lower active layer 222b may act as a isolation layer that structurally isolates the second upper active layer 222t and the second lower active layer 222b from each other.

As the first active layer 221 structurally isolates the second upper active layer 222t and the second lower active layer 222b from each other, the thickness of the second upper active layer 222t may be prevented from directly increasing significantly.

According to an exemplary embodiment of the present disclosure as described above, the active layer 220 is embodied as the stack of the plurality of layers with different carrier mobility, thereby allowing the threshold voltage to be more easily controlled in the active layer 220 based on high current characteristics.

Further, according to an exemplary embodiment of the present disclosure, a significant area of an effective channel area of the active layer 220 constituting the main channel may be made of a relatively high carrier mobility material. Thus, high current may be allowed to flow through the thin-film transistor, such that a display device with high luminance may be realized.

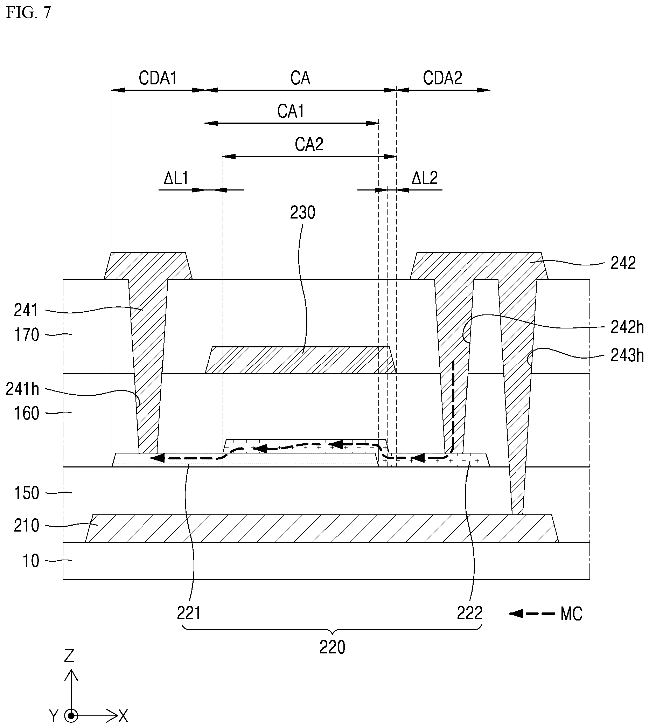

Referring to FIG. 7, in the thin-film transistor according to the fifth exemplary embodiment, the second active layer 222 extends toward the first electrode 241 so as to cover a top surface of the first active layer 221. Specifically, the second active layer 222 covers a portion of the top surface of the first active layer 221.

Therefore, the active layer 220 may be formed as a double layer composed of two layers, that is, a lower level layer and an upper level layer. For example, the active layer 220 comprises the first active layer 221 and the second active layer 222 of the lower level layer and the second active layer 222 of the upper level layer.

For example, the first active layer 221 and the second active layer 222 may be disposed in the lower level layer, and the second active layer 222 may be disposed in the upper level layer. Specifically, the first active layer 221 and a portion of the second active layer 222 may be disposed in the lower level layer, and the other portion of the second active layer 222 may be disposed in the upper level layer.

In this case, a length of the first channel area CA1 of the first active layer 221 disposed in the lower level layer is larger than a length of the second channel area CA2 of the second active layer 222 disposed in the lower level layer.

However, as the second channel area CA2 of the second active layer 222 disposed in the upper level layer extends toward the first electrode 241, a total length of the second active layer 222 may increase.

The second active layer 222 extends so as not to cover a partial area of the first channel area CA1 of the first active layer 221. Thus, the partial area of the first channel area CA1 of the first active layer 221 may be directly exposed to the gate electrode 230, without being limited thereto.

For example, the second active layer 222 in the upper level layer may extend as much as possible such an end thereof does not invade the first boundary area ΔL1.

As the second active layer 222 in the upper level layer is disposed to cover the top surface of the first active layer 221, the top surface of the second active layer 222 may be closer to the gate electrode 230 than a top surface of the first active layer 221 may be.

As the second active layer 222 of the high carrier mobility is located closer to the gate electrode 230 than the first active layer 221 of the low carrier mobility is, a strong gate field is applied to the second active layer 222. Thus, the second channel area CA2 of the second active layer 222 of the upper level layer may act as the main channel area. Therefore, it is possible to achieve the high current characteristic effect of the thin-film transistor.

Therefore, referring to FIG. 7, the main current MC flowing from the second electrode 242 may flow through the second channel area CA2 of the lower level layer and then the second channel area CA2 of the upper level layer and then may flow to the first electrode 241 through the first channel area CA1 of the lower level layer.

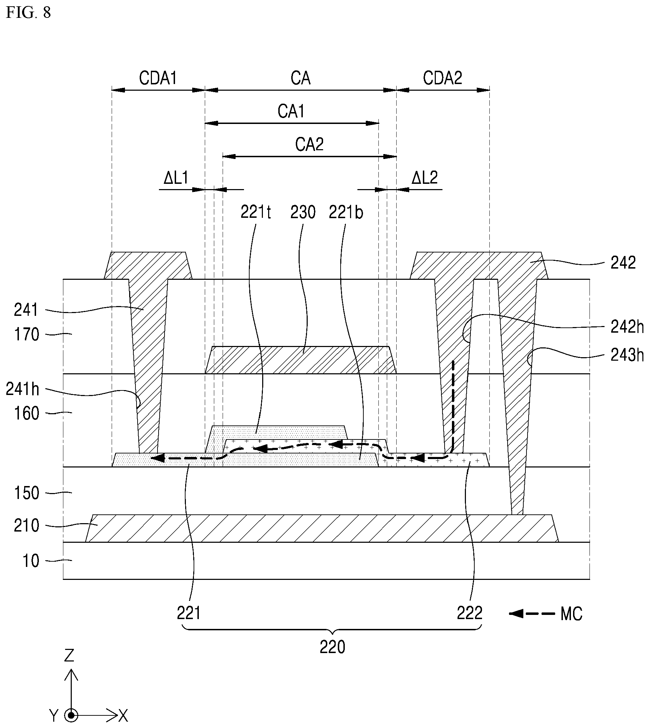

Referring to FIG. 8, the thin-film transistor according to the sixth embodiment of the present disclosure may include a multi-layer active layer 220 composed of a stack of three layers.

The first active layer 221 is constructed to include a first lower active layer 221b whose a partial area is covered with the second active layer 222, and a first upper active layer 221t extending from the first lower active layer 221b so as to cover at least a partial area of the second active layer 222 covering the first lower active layer 221b.

For example, the first active layer 221 and the second active layer 222 may be disposed in a lower level layer, the second active layer 222 may be disposed in a middle level layer, and the first active layer 221 may be disposed in a upper level layer.

As the first upper active layer 221t is disposed to cover a top surface of the second active layer 222, a top surface of the first upper active layer 221t may be closer to the gate electrode 230 than the top surface of the second active layer 222 may be.

As the first upper active layer 221t is located closer to the gate electrode 230 than the second active layer 222 is, the strong gate field is applied to the first active layer 221. Thus, the first channel area CA1 of the first active layer 221 may act as the main channel area.

When the first channel area CA1 of the low carrier mobility acts as the main channel area, it may be difficult to achieve the high current characteristic effect of the thin-film transistor.

Accordingly, according to an exemplary embodiment of the present disclosure, the difference between the carrier mobility of the second active layer 222 and the carrier mobility of the first active layer 221 may be set to be larger, and thus the second channel area CA2 of the second active layer 222 relatively further away from the gate electrode 230 may act as the main channel area. However, embodiments of the present disclosure are not limited thereto.

In this case, the carrier mobility of the second active layer 222 may be set to be higher by approximately 10 cm²/V·s than the carrier mobility of the first active layer 221. However, embodiments of the present disclosure are not limited thereto.

Accordingly, instead of the first channel area CA1 of the first upper active layer 221t closer to the gate electrode 230 than the second active layer 222, the second channel area CA2 of the second active layer 222 that is relatively further away from the gate electrode 230 may act as the main channel area. Thus, it is possible to achieve the high current characteristic effect of the thin-film transistor.

Therefore, referring to FIG. 8, the main current MC flowing from the second electrode 242 may flow through the second active layer 222 of the lower level layer and then the first channel area CA1 of the middle level layer and then the first active layer 221 of the lower level layer and then may flow to the first electrode 241.

The first channel area CA1 of the first upper active layer 221t located in the upper level layer and the first lower active layer 221b located in the lower level layer may function as a protective capping layer that protects the second channel area CA2 located in the middle level layer, and thus the reliability of the thin-film transistor may be improved.

During the process of forming the thin-film transistor, the active layer 220 constituting the channel area CA may be damaged during the process.

In this case, the first channel area CA1 of the first upper active layer 221t located in the upper level layer which does not constitute the main channel area and the first channel area CA1 of the first lower active layer 221b located in the lower level layer which does not constitute the main channel area may cover the upper and lower surfaces of the second channel area CA2, respectively and thus may function to prevent the damage to the second channel area CA2 of the middle level layer constituting the main channel area.

The active layer 220 is constructed such that the second active layer 222 of the high carrier mobility is surrounded with the first active layer 221 of the low carrier mobility in a sandwiched manner, and the second active layer 222 of the high carrier mobility spaces upper and lower portions of the first active layer 221 of the low carrier mobility from each other.

As the damage to the second channel area CA2 constituting the main channel area is reduced, the reliability of the thin-film transistor may be improved.

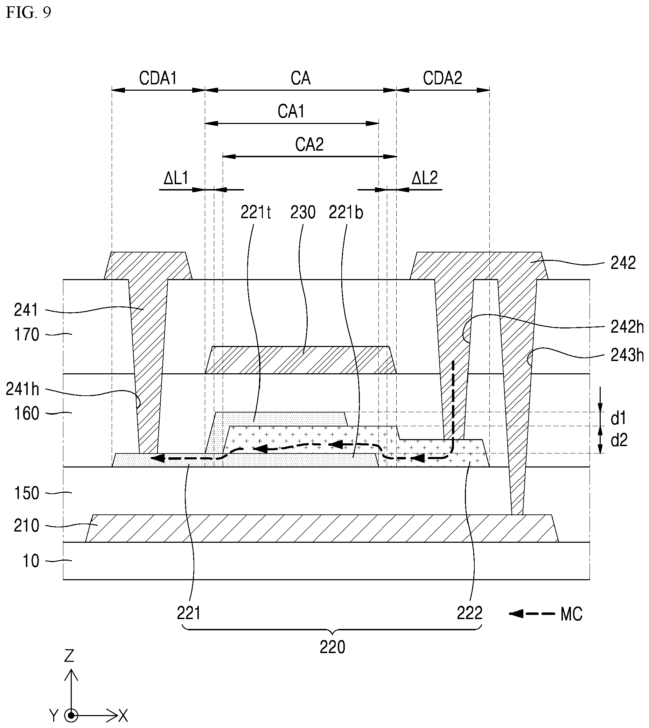

Further, referring to FIG. 9, the thin-film transistor according to the seventh embodiment of the present disclosure has a stack structure according to FIG. 8, and further has a structure in which the thickness d2 of the second active layer 222 is larger than the thickness d1 of the first upper active layer 221t.

Thus, when the thickness d2 of the second active layer 222 is larger than the thickness d1 of the first upper active layer 221t, the second channel area CA2 of the second active layer 222 may act as the main channel area even though the difference between the carrier mobility of the second active layer 222 and the carrier mobility of the first upper active layer 221t is not set to be large. However, embodiments of the present disclosure are not limited thereto. As another example, the thickness d2 of the second active layer 222 may be set to be larger than the thickness d1 of the first upper active layer 221t, and the difference between the carrier mobility of the second active layer 222 and the carrier mobility of the first upper active layer 221t may be set to be larger, thereby further achieving the high current characteristic effect of the thin-film transistor.

As the thickness of the second channel area CA2 of the second active layer 222 increases, a stronger gate field may be applied to the second channel area CA2. Thus, instead of the first channel area CA1 of the first upper active layer 221t closer to the gate electrode 230, the second channel area CA2 of the second active layer 222 relatively further away from the gate electrode 230 may act as the main channel area. Thus, it is possible to achieve the high current characteristic effect of the thin-film transistor.

Therefore, referring to FIG. 9, the main current MC flowing from the second electrode 242 may flow through the second channel area CA2 of the upper level layer and the first channel area CA1 of the lower level layer, and then may flow to the first electrode 241.

## Claims

1. A thin-film transistor comprising:
an active layer (220);
a first electrode (241) connected to one side of the active layer (220);
a second electrode (242) connected to an opposite side of the active layer (220) that is opposite to the one side of the active layer; and
a gate electrode (230) on top of the active layer (220),
wherein the active layer (220) includes a first active layer (221) connected to the first electrode (241) and a second active layer (222) connected to the second electrode (242),
wherein a carrier mobility of the first active layer (221) is less than a carrier mobility of the second active layer (222), and
wherein the second active layer (222) includes:
a second lower active layer (222b) including a partial area that is covered with the first active layer (221); and
a second upper active layer (222t) extending from the second lower active layer (222b) and covering at least a partial area of the first active layer (221) that covers the second lower active layer (222b).

2. The thin-film transistor of claim 1, wherein the active layer (220) includes a channel area in an area of the active layer that overlaps the gate electrode (230) in a vertical direction,
wherein the first active layer (221) and the second active layer (222) include a first channel area and a second channel area, respectively, wherein each of the first channel area and the second channel area is located in the channel area,
wherein at least a partial area of the first channel area is non-overlapping with the second channel area in the vertical direction.

3. The thin-film transistor of claim 1 or 2, wherein a top surface of the second active layer (222) is closer to the gate electrode (230) than a top surface of the first active layer (221).

4. The thin-film transistor of any one of claims 1 to 3, wherein the second upper active layer (222t) and the second lower active layer (222b) are formed to have the same carrier mobility.

5. The thin-film transistor of claim 2 or any one of claims 3 to 4 referring, directly or indirectly, back to claim 2, wherein the second upper active layer (222t) does not cover a partial area of the first channel area (CA1) of the first active layer (221), so that the partial area of the first channel area (CA1) of the first active layer (221) is directly exposed to the gate electrode (230).

6. A thin-film transistor comprising:
an active layer (220);
a first electrode (241) connected to one side of the active layer (220);
a second electrode (242) connected to an opposite side of the active layer (220) that is opposite to the one side of the active layer; and
a gate electrode (230) on top of the active layer (220),
wherein the active layer (220) includes a first active layer (221) connected to the first electrode (241) and a second active layer (222) connected to the second electrode (242),
wherein a carrier mobility of the first active layer (221) is less than a carrier mobility of the second active layer (222), and
wherein the first active layer (221) includes:
a first lower active layer (221b) including a partial area that is covered with the second active layer (222); and
a first upper active layer (221t) extending from the first lower active layer (221b) and covering at least a partial area of the second active layer (222) that covers the first lower active layer (221b).

7. The thin-film transistor of claim 6, wherein a top surface of the first active layer (221) is closer to the gate electrode (230) than a top surface of the second active layer (222).

8. The thin-film transistor of claim 6 or 7, wherein a thickness of the second active layer (222) is greater than a thickness of the first active layer (221).

9. The thin-film transistor of any one of claims 1 to 8, wherein the first active layer (221) is made of an oxide semiconductor material with a first carrier mobility, and the second active layer (222) is made of an oxide semiconductor material with a second carrier mobility higher than the first carrier mobility.

10. The thin-film transistor of any one of claims 1 to 9, wherein the first active layer (221) includes at least one of an IGZO (InGaZnO)-based oxide semiconductor material having Ga concentration greater than In concentration, a GZO (GaZnO)-based oxide semiconductor material, an IGO (InGaO)-based oxide semiconductor material, and a GZTO (GaZnSnO)-based oxide semiconductor material.

11. The thin-film transistor of any one of claims 1 to 10, wherein the second active layer (222) includes at least one of an IGZO (InGaZnO)-based oxide semiconductor material having In concentration greater than Ga concentration, an IZO (InZnO)-based oxide semiconductor material, an IGZTO (InGaZnSnO)-based oxide semiconductor material, a ITZO (InSnZnO)-based oxide semiconductor material, a FIZO (FeInZnO)-based oxide semiconductor material, a ZnO-based oxide semiconductor material, a SIZO (SiInZnO)-based oxide semiconductor material, and a ZnON (Zn-Oxynitride)-based oxide semiconductor material.

12. The thin-film transistor of any one of claims 1 to 11, wherein the first electrode (241) is a drain electrode, and the second electrode (242) is a source electrode.

13. A display device (1) comprising:
a light-emitting element; and
a driving thin-film transistor according to any one of claims 1 to 12.

## Patentansprüche

1. Dünnfilmtransistor, der Folgendes umfasst:
eine aktive Schicht (220);
eine erste Elektrode (241), die mit einer Seite der aktiven Schicht (220) verbunden ist;
eine zweite Elektrode (242), die mit einer gegenüberliegenden Seite der aktiven Schicht (220) verbunden ist, die der einen Seite der aktiven Schicht gegenüberliegt; und
eine Gate-Elektrode (230) auf der aktiven Schicht (220), wobei die aktive Schicht (220) eine erste aktive Schicht (221), die mit der ersten Elektrode (241) verbunden ist, und eine zweite aktive Schicht (222), die mit der zweiten Elektrode (242) verbunden ist, beinhaltet,
wobei eine Ladungsträgerbeweglichkeit der ersten aktiven Schicht (221) geringer als eine Ladungsträgerbeweglichkeit der zweiten aktiven Schicht (222) ist, und
wobei die zweite aktive Schicht (222) Folgendes beinhaltet:
eine zweite untere aktive Schicht (222b), die einen Teilbereich beinhaltet, der mit der ersten aktiven Schicht (221) bedeckt ist; und
eine zweite obere aktive Schicht (222t), die sich von der zweiten unteren aktiven Schicht (222b) erstreckt und wenigstens einen Teilbereich der ersten aktiven Schicht (221) bedeckt, der die zweite untere aktive Schicht (222b) bedeckt.

2. Dünnfilmtransistor nach Anspruch 1, wobei die aktive Schicht (220) einen Kanalbereich in einem Bereich der aktiven Schicht beinhaltet, der mit der Gate-Elektrode (230) in einer vertikalen Richtung überlappt,
wobei die erste aktive Schicht (221) und die zweite aktive Schicht (222) einen ersten Kanalbereich bzw. einen zweiten Kanalbereich beinhalten, wobei sich sowohl der erste Kanalbereich als auch der zweite Kanalbereich in dem Kanalbereich befinden,
wobei sich wenigstens ein Teilbereich des ersten Kanalbereichs in der vertikalen Richtung nicht mit dem zweiten Kanalbereich überlappt.

3. Dünnfilmtransistor nach Anspruch 1 oder 2, wobei eine obere Oberfläche der zweiten aktiven Schicht (222) näher an der Gate-Elektrode (230) als eine obere Oberfläche der ersten aktiven Schicht (221) ist.

4. Dünnfilmtransistor nach einem der Ansprüche 1 bis 3, wobei die zweite obere aktive Schicht (222t) und die zweite untere aktive Schicht (222b) so gebildet sind, dass sie die gleiche Ladungsträgerbeweglichkeit aufweisen.

5. Dünnfilmtransistor nach Anspruch 2 oder einem der Ansprüche 3 bis 4, unter direkter oder indirekter Bezugnahme auf Anspruch 2, wobei die zweite obere aktive Schicht (222t) keinen Teilbereich des ersten Kanalbereichs (CA1) der ersten aktiven Schicht (221) bedeckt, so dass der Teilbereich des ersten Kanalbereichs (CA1) der ersten aktiven Schicht (221) direkt der Gate-Elektrode (230) ausgesetzt ist.

6. Dünnfilmtransistor, der Folgendes umfasst:
eine aktive Schicht (220);
eine erste Elektrode (241), die mit einer Seite der aktiven Schicht (220) verbunden ist;
eine zweite Elektrode (242), die mit einer gegenüberliegenden Seite der aktiven Schicht (220) verbunden ist, die der einen Seite der aktiven Schicht gegenüberliegt; und
eine Gate-Elektrode (230) auf der aktiven Schicht (220),
wobei die aktive Schicht (220) eine erste aktive Schicht (221), die mit der ersten Elektrode (241) verbunden ist, und eine zweite aktive Schicht (222), die mit der zweiten Elektrode (242) verbunden ist, beinhaltet,
wobei eine Ladungsträgerbeweglichkeit der ersten aktiven Schicht (221) geringer als eine Ladungsträgerbeweglichkeit der zweiten aktiven Schicht (222) ist, und
wobei die erste aktive Schicht (221) Folgendes beinhaltet:
eine erste untere aktive Schicht (221b), die einen Teilbereich beinhaltet, der mit der zweiten aktiven Schicht (222) bedeckt ist; und
eine erste obere aktive Schicht (221t), die sich von der ersten unteren aktiven Schicht (221b) erstreckt und wenigstens einen Teilbereich der zweiten aktiven Schicht (222) bedeckt, der die erste untere aktive Schicht (221b) bedeckt.

7. Dünnfilmtransistor nach Anspruch 6, wobei eine obere Oberfläche der ersten aktiven Schicht (221) näher an der Gate-Elektrode (230) als eine obere Oberfläche der zweiten aktiven Schicht (222) ist.

8. Dünnfilmtransistor nach Anspruch 6 oder 7, wobei eine Dicke der zweiten aktiven Schicht (222) größer als eine Dicke der ersten aktiven Schicht (221) ist.

9. Dünnfilmtransistor nach einem der Ansprüche 1 bis 8, wobei die erste aktive Schicht (221) aus einem Oxidhalbleitermaterial mit einer ersten Ladungsträgerbeweglichkeit gefertigt ist und die zweite aktive Schicht (222) aus einem Oxidhalbleitermaterial mit einer zweiten Ladungsträgerbeweglichkeit gefertigt ist, die höher als die erste Ladungsträgerbeweglichkeit ist.

10. Dünnfilmtransistor nach einem der Ansprüche 1 bis 9, wobei die erste aktive Schicht (221) ein IGZO(InGaZnO)-basiertes Oxidhalbleitermaterial mit einer Ga-Konzentration größer als eine In-Konzentration und/oder ein GZO(GaZnO)-basiertes Oxidhalbleitermaterial und/oder ein IGO(InGaO)-basiertes Oxidhalbleitermaterial und/oder ein GZTO(GaZnSnO)-basiertes Oxidhalbleitermaterial beinhaltet.

11. Dünnfilmtransistor nach einem der Ansprüche 1 bis 10, wobei die zweite aktive Schicht (222) ein IGZO(InGaZnO)-basiertes Oxidhalbleitermaterial mit einer In-Konzentration größer als eine Ga-Konzentration und/oder ein IZO(InZnO)-basiertes Oxidhalbleitermaterial und/oder ein IGZTO(InGaZnSnO)-basiertes Oxidhalbleitermaterial und/oder ein ITZO(InSnZnO)-basiertes Oxidhalbleitermaterial und/oder ein FIZO(FelnZnO)-basiertes Oxidhalbleitermaterial und/oder ein ZnO-basiertes Oxidhalbleitermaterial und/oder ein SIZO(SiInZnO)-basiertes Oxidhalbleitermaterial und/oder ein ZnON(Zn-Oxinitrid)-basiertes Oxidhalbleitermaterial beinhaltet.

12. Dünnfilmtransistor nach einem der Ansprüche 1 bis 11, wobei die erste Elektrode (241) eine Drain-Elektrode ist und die zweite Elektrode (242) eine Source-Elektrode ist.

13. Anzeigevorrichtung (1), die Folgendes umfasst:
ein Lichtemissionselement; und
einen Ansteuerungsdünnfilmtransistor nach einem der Ansprüche 1 bis 12.

## Revendications

1. Transistor en couches minces comprenant :
une couche active (220) ;
une première électrode (241) connectée à un côté donné de la couche active (220) ;
une deuxième électrode (242) connectée à un côté opposé de la couche active (220), lequel est opposé au côté donné de la couche active ; et
une électrode de grille (230) située au-dessus de la couche active (220),
dans lequel la couche active (220) comporte une première couche active (221) connectée à la première électrode (241) et une deuxième couche active (222) connectée à la deuxième électrode (242),
dans lequel une mobilité des porteurs de charge de la première couche active (221) est inférieure à une mobilité des porteurs de charge de la deuxième couche active (222), et
dans lequel la deuxième couche active (222) comporte :
une deuxième couche active inférieure (222b) comportant une zone partielle qui est recouverte par la première couche active (221) ; et
une deuxième couche active supérieure (222t) s'étendant depuis la deuxième couche active inférieure (222b) et recouvrant au moins une zone partielle de la première couche active (221) qui recouvre la deuxième couche active inférieure (222b).

2. Transistor en couches minces selon la revendication 1, dans lequel la couche active (220) comporte une zone de canal dans une zone de la couche active qui chevauche l'électrode de grille (230) dans une direction verticale, dans lequel la première couche active (221) et la deuxième couche active (222) comportent respectivement une première zone de canal et une deuxième zone de canal, chacune de la première zone de canal et de la deuxième zone de canal étant située dans la zone de canal,
dans lequel au moins une zone partielle de la première zone de canal ne chevauche pas la deuxième zone de canal dans la direction verticale.

3. Transistor en couches minces selon la revendication 1 ou 2, dans lequel une surface de dessus de la deuxième couche active (222) est plus proche de l'électrode de grille (230) qu'une surface de dessus de la première couche active (221).

4. Transistor en couches minces selon l'une quelconque des revendications 1 à 3, dans lequel la deuxième couche active supérieure (222t) et la deuxième couche active inférieure (222b) sont formées de manière à présenter la même mobilité des porteurs de charge.

5. Transistor en couches minces selon la revendication 2 ou l'une quelconque des revendications 3 à 4 renvoyant, directement ou indirectement, à la revendication 2, dans lequel la deuxième couche active supérieure (222t) ne recouvre pas une zone partielle de la première zone de canal (CA1) de la première couche active (221), de sorte que la zone partielle de la première zone de canal (CA1) de la première couche active (221) est directement exposée à l'électrode de grille (230).

6. Transistor en couches minces comprenant :
une couche active (220) ;
une première électrode (241) connectée à un côté donné de la couche active (220) ;
une deuxième électrode (242) connectée à un côté opposé de la couche active (220), lequel est opposé au côté donné de la couche active ; et
une électrode de grille (230) située au-dessus de la couche active (220),
dans lequel la couche active (220) comporte une première couche active (221) connectée à la première électrode (241) et une deuxième couche active (222) connectée à la deuxième électrode (242),
dans lequel une mobilité des porteurs de charge de la première couche active (221) est inférieure à une mobilité des porteurs de charge de la deuxième couche active (222), et
dans lequel la première couche active (221) comporte :
une première couche active inférieure (221b) comportant une zone partielle qui est recouverte par la deuxième couche active (222) ; et
une première couche active supérieure (221t) s'étendant depuis la première couche active inférieure (221b) et recouvrant au moins une zone partielle de la deuxième couche active (222) qui recouvre la première couche active inférieure (221b).

7. Transistor en couches minces selon la revendication 6, dans lequel une surface de dessus de la première couche active (221) est plus proche de l'électrode de grille (230) qu'une surface de dessus de la deuxième couche active (222).

8. Transistor en couches minces selon la revendication 6 ou 7, dans lequel une épaisseur de la deuxième couche active (222) est supérieure à une épaisseur de la première couche active (221).

9. Transistor en couches minces selon l'une quelconque des revendications 1 à 8, dans lequel la première couche active (221) est constituée d'un matériau de type oxyde semi-conducteur présentant une première mobilité des porteurs de charge, et la deuxième couche active (222) est constituée d'un matériau de type oxyde semi-conducteur présentant une deuxième mobilité des porteurs de charge supérieure à la première mobilité des porteurs de charge.

10. Transistor en couches minces selon l'une quelconque des revendications 1 à 9, dans lequel la première couche active (221) comporte au moins l'un des matériaux suivants : un matériau de type oxyde semi-conducteur à base d'IGZO (InGaZnO) dont la concentration en Ga est supérieure à la concentration en In, un matériau de type oxyde semi-conducteur à base de GZO (GaZnO), un matériau de type oxyde semi-conducteur à base d'IGO (InGaO) et un matériau de type oxyde semi-conducteur à base de GZTO (GaZnSnO).

11. Transistor en couches minces selon l'une quelconque des revendications 1 à 10, dans lequel la deuxième couche active (222) comporte au moins l'un des matériaux suivants : un matériau de type oxyde semi-conducteur à base d'IGZO (InGaZnO) dont la concentration en In est supérieure à la concentration en Ga, un matériau de type oxyde semi-conducteur à base d'IZO (InZnO), un matériau de type oxyde semi-conducteur à base d'IGZTO (InGaZnSnO), un matériau de type oxyde semi-conducteur à base d'ITZO (InSnZnO), un matériau de type oxyde semi-conducteur à base de FIZO (FeInZnO), un matériau de type oxyde semi-conducteur à base de ZnO, un matériau de type oxyde semi-conducteur à base de SIZO (SiInZnO) et un matériau de type oxyde semi-conducteur à base de ZnON (oxynitrure de Zn).

12. Transistor en couches minces selon l'une quelconque des revendications 1 à 11, dans lequel la première électrode (241) est une électrode de drain, et la deuxième électrode (242) est une électrode de source.

13. Dispositif d'affichage (1) comprenant :
un élément électroluminescent ; et
un transistor en couches minces de pilotage selon l'une quelconque des revendications 1 à 12.
